# EUROPÄISCHE PATENTSCHRIFT

(11) **EP 0 362 745 B1**
(45) Veröffentlichungstag und Bekanntmachung des Hinweises auf die Patenterteilung: **01.06.1994**
(21) Anmeldenummer: 89118177.8
(22) Anmeldetag: 30.09.1989
(51) Int. Cl.: G01R 1/36

(54) **Elektronisches Mehrbereichsmessgerät**
Electronic multimeter
Multimètre électronique

(30) Priorität: 07.10.1988 DE 3834183
(43) Veröffentlichungstag der Anmeldung: 11.04.1990
(73) Patentinhaber: Gossen- Metrawatt GmbH, D-8500 Nürnberg (DE)
(72) Erfinder: Hochreuther, Karl, D-8500 Nürnberg (DE); Ziegler, Herbert, D-8500 Nürnberg (DE); Kindermann, Robert, D-8500 Nürnberg (DE)
(74) Vertreter: Hafner, Dieter, Dr.rer.nat., Dipl.-Phys.

(56) Entgegenhaltungen:
- GB-A- 2 080 956
- US-A- 2 641 630
- US-A- 3 648 166
- US-A- 3 710 252

## Beschreibung

Die Erfindung betrifft ein Meßgerät der im Oberbegriff des Anspruchs 1 genannten Art.

Elektronische Mehrbereichsmeßgeräte, insbesondere Vielfachmeßgeräte mit hohem Eingangswiderstand, werden bevorzugt im Labor- und Elektronikbereich verwendet. Höhere Spannungen als die Netzspannung von 220 V treten hier gewöhnlich nicht auf, so daß es genügt, diese Geräte gegen Überspannungen bis 1 kV, durch einen Überspannungsableiter zu schützen, der als Funkenstrecke oder spannungsabhängiger Widerstand ausgebildet sein kann. Selbst wenn die mit einem Überspannungsableiter und einer Sicherung oder einem Kaltleiter versehene Schutzeinrichtung versagen sollte, bieten die im Netz vorgesehenen Sicherungen von 16 A oder 20 A zumindest für den Bediener des Meßgerätes genügend Schutz, so daß nur Materialschaden entstehen kann.

Demgegenüber ist die Verwendung von üblichen Multimetern in Schalt- und Verteileranlagen mit einer Absicherung von mindestens 35 A und einer hohen Kurzschlußstromergiebigkeit (> 2000 A) mit erheblichen Gefahren nicht nur für die Funktion des Meßgerätes sondern auch für den Bedienenden verbunden. In diesem Bereich können Abschaltvorgänge in Verbindung mit induktiven Lasten oder Kurzschlüsse zu Spannungsspitzen führen, die bis zu einem zehnfachen Wert der Nennspannung ansteigen. Zwar spricht in diesem Fall der als Schutz in der Eingangsschaltung des Multimeters vorgesehene Überspannungsableiter an, kann jedoch die hierbei auftretenden relativ hohen Ströme nicht begrenzen. Als Strombegrenzungsmittel ist in der Regel eine Sicherung oder ein Widerstand vorgeschaltet, deren Abschaltfähigkeit jedoch weit überschritten wird. Es entsteht dadurch ein Lichtbogen, der auch nach Abfall des Überspannungsimpulses bestehen bleibt und durch Überlastung zu einer explosionsartigen Zerstörung des Überspannungsableiters führen kann.

Zu einer gleichartigen Gefährdung für Personen und Material kann eine Fehlbedienung des Multimeters führen, bei der z.B. anstatt auf einen Spannungsmeßbereich auf einen Strom- oder Widerstandsmeßbereich geschaltet wird.

Aus den genannten Gründen sollten in Niederspannungsschaltanlagen Spannungen nicht mit Multimetern gemessen werden. Die Gefahr versehentlich einen Strombereich zu wählen oder das Meßgerät unzulässig hohen Spannungsspitzen auszusetzen, ist zu groß. In diesem Bereich bevorzugt man deshalb ausschließlich für Spannungsmessungen ausgelegte Geräte.

Aus GB-A-2080956 geht ein Mehrbereichsmeßgerät hervor, das eine Eingangsschaltung aufweist, die unter Verwendung eines Überspannungsableiters gefährliche Überspannungen eliminiert.

Aus US-A-2641630 ist ferner ein Spannungsteilertastkopf bekannt, der eine Meßspannung durch Verwendung eines Serien Widerstandes auf einen für das Meßgerät und die Bedienungsperson verträglichen Wert reduziert.

Aufgabe der Erfindung ist es, übliche Mehrfachmeßgeräte mit Spannungs-, Strom- und ggf. auch Widerstandsbereichen, so aufzubauen, daß sie ohne ein unzumutbar hohes Sicherheitsrisiko auch in Niederspannungsanlagen verwendbar sind, wo Überspannungsspitzen von mehreren Kilovolt auftreten können. Dabei sollen die von Überspannungen ebenso wie die von Fehlbedienungen des Mehrbereichsmeßgerätes ausgehenden Gefahren beseitigt werden.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Ein wesentlicher Vorteil der Erfindung ist, daß die Mehrbereichsmeßgeräte in ihrem Aufbau unverändert belassen werden können, und allein durch Austausch einer Meßleitung, in der sich nunmehr ein Meßadapter befindet, ihr Anwendungsbereich auch auf Niederspannungsanlagen ausgedehnt werden kann. Da es gelingt den Schutzwiderstand auf ca. 15 kOhm zu begrenzen, führt dieser in Verbindung mit einem Eingangswiderstand des Multimeters von ca. 10 MOhm zu einem zusätzlichen Meßfehler von nur 0,15 %. Bei einem Grundfehler des Multimeters von ca. 1 % sind derartige Abweichungen tolerierbar.

Aus dem Bereich der Oszilloskopmeßtechnik ist es zwar bekannt als Meßadapter wirkende Meßköpfe zu verwenden, doch ist deren Funktion auf die Lösung meßtechnischer Probleme gerichtet. Ein Meßadapter, der aus meßtechnischer Sicht das Meßergebnis verschlechtert, und ausschließlich zum Schutz des Meßgerätes und der bedienenden Person vorgesehen ist, erfordert völlig neuartige Überlegungen.

Auch Meßgeräte, die unmittelbar in die Meßspitzen eingebaut sind, vermögen keinen Hinweis zur Lösung der erfindungsgemäßen Aufgabe zu geben, da sie nur äußerlich als Meßadapter erscheinen, ihre Sicherheit jedoch in gleicher Weise über Störspannungen und Fehlbedienung beeinträchtigt werden kann.

In Weiterbildung des Erfindungsgegenstandes kann als Schutzwiderstand ein Begrenzungsnetzwerk dienen, das aus mehreren in Reihe geschalteten Einzelwiderständen besteht und dadurch eine gute Wärmeableitung ermöglicht, sowie relativ hohe Spannungen verträgt. Der Schutzwiderstand kann in seiner Wirksamkeit wesentlich verbessert werden, indem mindestens einer der in Reihe liegenden Widerstände des Begrenzungsnetzwerks als PTC-Widerstand, also als Widerstand mit einem positiven Temperaturkoeffizienten, ausgebildet ist.

Die Wirksamkeit des Schutzwiderstandes hängt im wesentlichen von der Dimensionierung des Begrenzungsnetzwerkes ab. Hierbei ist einmal der Gesamtwiderstand der in Reihe liegenden Einzelwiderstände von Bedeutung und weiterhin das Verhältnis des PTC-Widerstandes zum verbleibenden Restwiderstand zu beachten. Die Dimensionierung muß so erfolgen, daß der Widerstand des Netzwerkes bei Überspannungen den Eingangsstrom auf einen für die Eingangsschaltung des Mehrbereichsmeßgerätes ungefährlichen Wert begrenzt und einen in der Eingangsschaltung des Mehrbereichsmeßgerätes entstandenen Lichtbogen zum Erlöschen bringt. Andererseits muß in Fällen der Fehlbedienung, bei denen kein Lichtbogen entsteht, der die Einzelwiderstände gefährdende Überstrom auf einen zulässigen Wert reduziert werden. Diese Funktion übernimmt ein in Reihe zu den Einzelwiderständen geschalteter PTC-Widerstand, der nach Ansprechen den Eingangsstrom auf einen für die Eingangsschaltung und die Einzelwiderstände ungefährlichen Wert begrenzt.

Um mit relativ preisgünstigen Widerständen auszukommen, ist es zweckmäßig die Zahl der in Reihe liegenden Einzelwiderständen so zu wählen, daß Einzelwiderstände für relativ geringe Verlustleistung und mit relativ geringer Nennspannung verwendbar sind, die jedoch insgesamt die benötigte Spannungsfertigkeit bei anliegender Überspannung aufweisen und bis zum Auslösen des PTC-Widerstandes die benötigte Verlustleistung aufnehmen.

Sollte wider Erwarten einer der Widerstände des Begrenzungsnetzwerkes durch Überlastung zu einer Unterbrechung des Stromkreises führen oder die in der Eingangsschaltung des Mehrbereichsmeßgerätes liegende Sicherung ansprechen, so könnte trotz anliegender Meßspannung durch die fehlende Anzeige des Meßgerätes eine Spannungslosigkeit des Meßobjektes vorgetäuscht werden. Auch eine Fehlbedienung des Meßgerätes kann zu einer solchen Täuschung führen. Damit in einem solchen Fall der Bediener nicht zu einem Fehlschluß verleitet wird, ist es vorteilhaft den Schutzwiderstand durch einen Redundanzwiderstand zu überbrücken, wobei dessen Widerstand mindestens um eine Größenordnung hochohmiger als der Schutzwiderstand ist. Hierdurch wird auch bei unterbrochenem Schutzwiderstand eine Meßspannung, allerdings mit erhöhtem Meßfehler, am Meßgerät angezeigt.

Noch deutlicher ist die Aussage, die man durch ein Signalelement erhält, das mit seinen zugehörigen Vorwiderständen den Schutzwiderstand und den in Reihe liegenden Eingang des Mehrbereichsmeßgerätes überbrückt und eine Unterbrechung im gesamten Eingangsmeßkreis des Meßgerätes durch seine Anzeige sichtbar macht. Nur wenn eine Anzeige des Meßgerätes als auch des Signalelementes fehlt, kann der Bediener davon ausgehen, daß das Meßobjekt ohne Spannung ist, bzw. max. die Ansprechspannung des Signalelements führt.

Obwohl es im Prinzip denkbar ist, den Schutzwiderstand in eine der beiden Meßleitungen zu integrieren, ist es konstruktiv vorzuziehen, den Meßadapter mit einem Gehäuse zu versehen, in dem der Schutzwiderstand und ggf. die weiteren Bauteile untergebracht und vorzugsweise auf einer Leiterplatte montierbar sind. Bei einer vorteilhaften Ausgestaltung des Gehäuses kann an seinem freien, nicht mit der Meßleitung verbundenen Ende ein Kontaktelement vorzugsweise eine Meßspitze angebracht werden und durch geeignete Formgebung dafür gesorgt werden, daß das Gehäuse bei der Kontaktierung des Meßobjektes bequem in einer Hand gehalten werden kann.

Ausführungsbeispiele der Erfindung sind in den Zeichnungen dargestellt und werden im folgenden näher beschrieben.

Es zeigen:
- Figur 1:: Ein Schaltbild des Meßadapters mit nachgeschaltetem Multimeter,
- Figur 2:: den mechanischen Aufbau des Meßadapters von oben,
- Figur 3:: den mechanischen Aufbau des Meßadapters von der Seite, jeweils einseitig geöffnet.

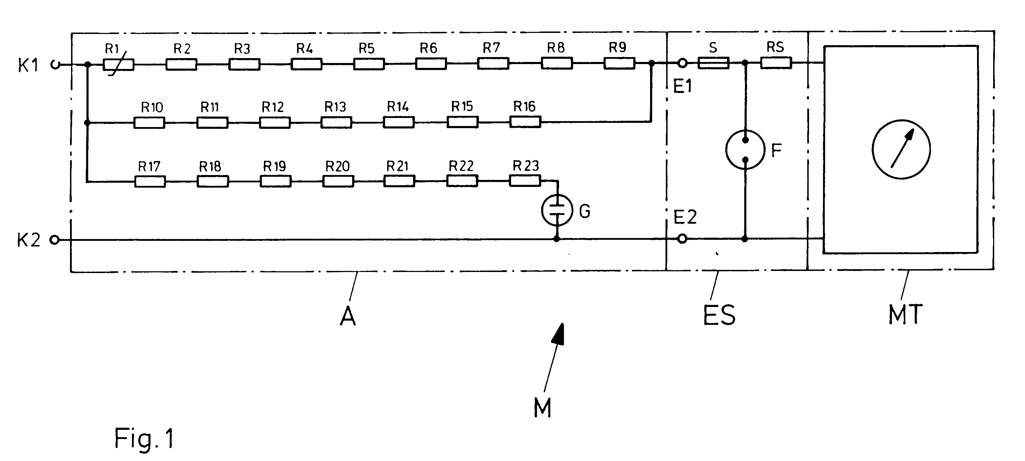

Wie Figur 1 zeigt, besteht das Mehrbereichsmeßgerät aus einem Meßteil MT, einer vorgeschalteten Eingangsschaltung ES und einem Meßadapter A, der mit mindestens einem der beiden Eingänge E1, E2 der Eingangsschaltung ES verbunden ist. Die Eingangsschaltung ES dient zum Schutz des Meßteils MT vor Überspannungen und ist hierzu mit einer Funkenstrecke F ausgestattet, die über einen Widerstand RS den Eingang des Meßteils MT kurzschließt. Zur Begrenzung des über die Funkenstrecke F fließenden Stromes ist eine Schmelzsicherung S vorgeschaltet, die bei einer entsprechenden Höhe und Dauer des Stromes den Meßkreis unterbricht. Eingangsschaltungen dieser Art können in ihrem Aufbau variieren und z.B. auch anstelle der Funkenstrecke mit einem spannungsabhängigen Widerstand (Varistor) ausgestattet sein. Ihnen allen liegt jedoch das Prinzip zugrunde, daß Überspannungen, die einen bestimmten Grenzwert überschreiten, quasi kurzgeschlossen werden.

Während im Normalbetrieb der von der Eingangsschaltung gewährleistete Schutz völlig ausreicht, können in Schalt- und Verteileranlagen energiereiche Spannungsimpulse über 1 kV erzeugt werden. Diese Spannungen führen zwar zu einem Ansprechen des als Varistor oder als Funkenstrecke aufgebauten Überspannungsableiters, doch die Schmelzsicherung S ist nicht in der Lage, die dabei auftretenden Ströme durch Unterbrechung abzuschalten.

Zur Begrenzung des im Überspannungsfall dem Eingang E1 der Eingangsschaltung ES zugeführten Stromes ist diesem ein Adapter A vorgeschaltet, der in seiner Grundausstattung einen Schutzwiderstand R1 bis R9 enthält. Dieser Schutzwiderstand liegt in Reihe zu einer Meßleitung, die sich zwischen dem Eingang E1 der Eingangsschaltung ES und einem das Meßobjekt kontaktierenden Meßkontakt K1 erstreckt.

Damit die im Überspannungsfall am Schutzwiderstand R1 bis R9 auftretenden hohen Spannungen nicht zu einem Überschlag führen können, ist dieser in mehrere Einzelwiderstände unterteilt. Gleichzeitig gelingt hierdurch auch eine bessere Ableitung der durch die am Schutzwiderstand abfallende Verlustleistung erzeugten Wärme.

Die Wirksamkeit der Schutzschaltung wird durch einen Kaltleiter R1, der mit den übrigen, vorzugsweise als Draht- oder Metallschicht-Widerstand ausgeführten Widerständen R2-R9 in Reihe liegt, wesentlich erhöht. Hierbei ist zu berücksichtigen, daß unter dem Gesichtspunkt der Meßgenauigkeit, der Schutzwiderstand R1 bis R9 möglichst niedrig sein sollte. Sein Maximalwert wird durch den Eingangswiderstand der Eingangsschaltung ES bestimmt, der seinerseits wiederum vom Eingangswiderstand des Meßteils MT abhängt. Um jedoch seine Aufgabe einer ausreichenden Strombegrenzung erfüllen zu können, darf der Schutzwiderstand einen Mindestwert nicht unterschreiten. Soll die Schutzschaltung für Überspannungen bis 8 kV dimensioniert werden, so ist es vorteilhaft dem PTC-Widerstand R1 einen Widerstand von 7,5 kOhm zu geben und die übrigen Einzelwiderstände R2 bis R9 jeweils mit einem Wert von 500 bis 1000 Ohm zu versehen.

Damit der Bedienende auch in solchen Fällen noch eine Anzeige erhält, wenn wider Erwarten der Schutzwiderstand R1 bis R9 an irgendeiner Stelle den Meßkreis unterbricht, kann ggf. ein Redundanzwiderstand R10 bis R16 dem Schutzwiderstand R1 bis R9 parallel geschaltet werden. Der Redundanzwiderstand R10 bis R16 ist wesentlich hochohmiger ausgelegt als der Schutzwiderstand R1 bis R9 und würde dadurch zu einem größeren Meßfehler führen, was jedoch insofern unerheblich ist, weil seine Aufgabe allein darin besteht, eine anliegende Meßspannung zu signalisieren. Gegebenenfalls kann man einen Taster in Reihe zum Redundanzwiderstand R10 bis R16 legen, so daß dieser nur im Testfall zum Schutzwiderstand R1 bis R9 parallel geschaltet wird.

Eine Spannungs-Signalisierung kann auch mit Hilfe einer Glimmlampe G erfolgen, die mit ihrem Vorwiderstand R17 bis R23 den Schutzwiderstand R1 bis R9 und den hiermit in Reihe liegenden Eingang E1, E2 der Eingangsschaltung ES überbrückt. Eine solche Schaltung hat den Vorteil, daß sie auch dann anliegende Meßspannungen signalisiert, wenn die Sicherung der Eingangsschaltung ES durchgebrannt sein sollte oder im Meßteil MT des Mehrbereichsmeßgerätes ein Fehler auftritt. Für einen ansteckbaren Adapter, wie er vorzugsweise verwendet werden soll, ist jedoch von Nachteil, daß dieser zweipolig ausgeführt sein müßte, um auch eine Verbindung zum zweiten Eingang E2 der Eingangsschaltung herzustellen.

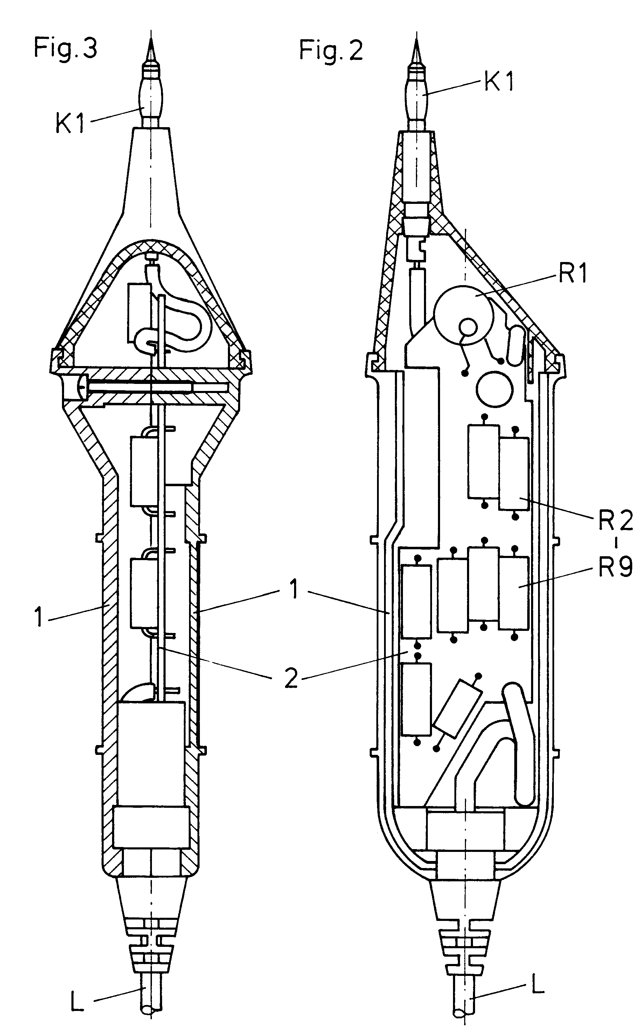

In den Figuren 2 und 3 ist der mechanische Aufbau des Meßadapters A dargestellt. Am Ende einer Meßleitung L ist ein Meßadaptergehäuse 1 befestigt, das an seinem freien Ende mit einem als Meßspitze ausgebildeten Kontaktierungsteil K1 versehen ist. Zwischen einem Anschluß an der Meßleitung L und dem Kontaktierungsteil K1 liegt eine Leiterplatte, auf der die in Reihe geschalteten Einzelwiderstände R1 bis R9 des Schutzwiderstandes angeordnet sind. Der als Kaltleiter wirkende PTC-Widerstand R1 dessen Temperatur im Störungsfall auf besonders hohe Werte ansteigen kann, befindet sich in der Nähe des Kontaktteils K1, das somit einen Teil der Wärme abführen kann.

## Patentansprüche

1. Elektronisches Mehrbereichsmeßgerät (M) mit Strom-und Spannungsmeßbereichen, das gegen Überspannungen durch eine Eingangsschaltung (ES) geschützt ist, in der sich allein oder in Verbindung mit weiteren elektrischen Bauteilen ein Überspannungsableiter befindet, der gefährliche Überspannungen eliminiert, und das mit vorzugsweise durch Stecker lösbaren Meßleitungen (L) versehen ist, dadurch gekennzeichnet, daß zur Spannungsmessung in Niederspannungsanlagen an mindestens einen von zwei Eingangsanschlüssen (E1,E2) der Eingangsschaltung (ES) des Mehrbereichsmeßgerätes (M) ein Meßadapter (A) angeschlossen ist, der einen den Widerstand der Meßleitung (L) wesentlich erhöhenden Schutzwiderstand (R1 bis R9) enthält und dessen Widerstand so dimensioniert ist, daß er bei Überspannungen von über 1 kV und auch bei Fehlbedienung durch Wahl eines Strombereiches zur Spannungsmessung, den in die Eingangsschaltung (ES) des Mehrbereichsmeßgerätes (M) fließenden Strom auf einen Wert begrenzt, der unter Berücksichtigung der in der Eingangsschaltung (ES) vorgesehenen Schutzmittel (S,R24,F) die Funktionsfähigkeit des Mehrbereichsmeßgerätes (M) nicht gefährdet und gleichzeitig unter Berücksichtigung der vorgegebenen Meßgenauigkeit einen vom Eingangswiderstand eines Meßteils (MT) des Mehrbereichsmeßgerätes (M) abhängigen Höchstwert nicht überschreitet.

2. Meßgerät nach Anspruch 1, dadurch gekennzeichnet, daß als Schutzwiderstand ein Begrenzungsnetzwerk dient, das eine gute Wärmeableitung ermöglicht, hohe Spannungen verträgt und vorzugsweise aus mehreren in Reihe geschalteten Einzelwiderständen (R1 bis R9) besteht.

3. Meßgerät nach einem der vorhergehenden Ansprüche, dadurch gekennzeichnet, daß mindestens einer (R1) der in Reihe liegenden Widerstände (R1 bis R9) ein PTC-Widerstand (R1) ist.

4. Meßgerät nach einem der vorhergehenden Ansprüche, dadurch gekennzeichnet, daß die Dimensionierung der in Reihe liegenden Widerstände (R1 bis R9) so erfolgt, daß der Gesamtwiderstand den Eingangsstrom auf einen für die Eingangsschaltung des Mehrbereichsmeßgerätes ungefährlichen Wert begrenzt und entstandene Lichtbogen erlöschen und der PTC-Widerstand nach seinem Ansprechen die an den übrigen in Reihe liegenden Einzelwiderständen entstehende Verlustleistung auf einen zulässigen Wert begrenzt.

5. Meßgerät nach einem der vorhergehenden Ansprüche, dadurch gekennzeichnet, daß die Zahl der in Reihe liegenden Einzelwiderstände (R1-R9) so gewählt ist, daß Einzelwiderstände für relativ geringe Verlustleistung und mit relativ geringer Nennspannung verwendbar sind, die die benötigte Verlustleistung bei anliegender Überspannung aufnehmen.

6. Meßgerät nach einem der vorhergehenden Ansprüche, dadurch gekennzeichnet, daß zu dem Schutzwiderstand (R1 bis R9) ein Redundanzwiderstand (R10 bis R16) parallel geschaltet werden kann, der um mindestens eine Größenordnung hochohmiger als der Schutzwiderstand (R1 bis R9) ist.

7. Meßgerät nach einem der vorhergehenden Ansprüche, dadurch gekennzeichnet, daß ein Signalelement (G) mit seinen zugehörigen hochohmigen Vorwiderständen (R17 bis R23) den Schutzwiderstand (R1 bis R9) und den in Reihe liegenden Eingang (E1,E2) des Mehrbereichsmeßgerätes (M) überbrückt.

8. Meßgerät nach einem der vorhergehenden Ansprüche, dadurch gekennzeichnet, daß der Meßadapter ein als Meßsonde gestaltetes Gehäuse (1) besitzt, in dem der Schutzwiderstand (R1 bis R9) und ggf. weitere Bauteile (R10 bis R23, G) untergebracht und vorzugsweise auf einer Leiterplatte (2) im Gehäuse (1) montiert sind.

9. Meßgerät nach einem der vorhergehenden Ansprüche, dadurch gekennzeichnet, daß das Gehäuse (1) an seinem freien nicht mit der Meßleitung (L) verbundenen Ende mit einem Kontaktelement (K1) vorzugsweise einer Meßspitze, versehen und so gestaltet ist, daß es bequem mit einer Hand gehalten werden kann.

## Claims

1. Electronic multimeter (M) with current and voltage ranges, which is protected against overvoltages by an input current (ES) in which there is, alone or in combination with further electrical components, an overvoltage suppressor which eliminates dangerous overvoltages, the multimeter being provided with testing leads which are detachable, preferably by means of plugs, characterised in that, for voltage measurements in low-voltage systems, a measurement adapter (A) is connected to at least one of two input connections (E1, E2) of the input circuit (ES) of the multimeter (M), and includes a protective resistor (R1 to R9) which considerably increases the resistance of the testing lead (L), and the resistance of which is dimensioned in a manner such that, with overvoltages of over 1 kV and also in the event of misoperation by the selection of a current range for voltage measurements, it limits the current flowing into the input circuit (ES) of the multimeter (M) to a value which, taking account of the protection means (S, R24, F) provided in the input circuit (ES), does not endanger the functionality of the multimeter (M) and, at the same time, taking account of the predetermined accuracy of measurement, does not exceed a maximum value which depends on the input resistance of a measurement portion (MT) of the multimeter (M).

2. Meter according to Claim 1, characterised in that a limiting circuit which serves as the protective resistor permits goods heat dissipation, tolerates high voltages and, preferably, consists of a plurality of individual resistors (R1 to R9) connected in series.

3. Meter according to any one of the preceding claims, characterised in that at least one (R1) of the resistors (R1 to R9) disposed in series is a PTC resistor (R1).

4. Meter according to any one of the preceding claims, characterised in that the resistors (R1 to R9) disposed in series are dimensioned in a manner such that the total resistance limits the input current to a value which is not dangerous to the input circuit of the multimeter and extinguishes arcs which arise and, after its response, the PTC resistor limits to an acceptable value the power dissipation to the remaining individual resistors disposed in series.

5. Meter according to any one of the preceding claim, characterised in that the number of individual resistors (R1-R9) disposed in series is selected in a manner such that the individual resistors are usable for relatively low power dissipation and with a relatively low nominal voltage and accommodate the necessary power dissipation when an overvoltage is connected.

6. Meter according to any one of the preceding claims, characterised in that a redundancy resistor (R10 to R16) with a resistance which is higher than that of the protective resistor (R1 to R9) by at least one order of magnitude, may be connected in parallel with the protective resistor (R1 to R9).

7. Meter according to any one of the preceding claims, characterised in that a signal element (G) with its associated high-resistance protective resistors (R17 to R23) bypasses the protective resistor (R1 to R9) and the input (E1, E2) of the multimeter (M) disposed in series.

8. Meter according to any one of the preceding claims, characterised in that the measurement adapter comprises a housing (1) formed as a measuring head, in which the protective resistor (R1 to R9) and, if necessary, further components (R10 to R23, G) are housed and are preferably mounted on a circuit board (2) in the housing (1).

9. Meter according to any one of the preceding claims, characterised in that the housing (1) has a contact element (K1), preferably a test prod, at its free end which is not connected to the testing lead (L), and is formed in a manner such that it can conveniently be held in one hand.

## Revendications

1. Multimètre électronique (M) apte à la mesure de courant et de tension, qui est protégé contre des surtensions par un circuit d'entrée (ES), dans lequel se trouve, seul ou en liaison avec d'autres composants électriques, un moyen pour éliminer les surtensions dangereuses, l'appareil étant muni de câbles de mesure (L) de préférence détachables au moyen de fiches, caractérisé en ce que, pour la mesure de tension dans des installations à basse tension, il est raccordé, à au moins l'une de deux bornes d'entrée (E1, E2) du circuit d'entrée (ES) du multimètre (M), un adaptateur de mesure (A) qui comprend une résistance protectrice (R1 à R9) augmentant sensiblement la résistance du câble de mesure (L) et dont la résistance est dimensionnée de telle manière que, lors de surtensions dépassant 1 kV et également lors d'une fausse manoeuvre concernant un choix d'une plage de courants pour la mesure de la tension, le courant circulant dans le circuit d'entrée (ES) du multimètre (M) soit limité à une valeur qui, compte tenu des moyens de protection (S, R24, F) prévus dans le circuit d'entrée (ES), ne met pas en péril l'aptitude au fonctionnement du multimètre (M) et, en même temps, compte tenu de la précision de mesure prédéterminée, ne dépasse pas une valeur limite supérieure, qui dépend de la résistance d'entrée d'une partie mesure (MT) du multimètre (M).

2. Appareil de mesure selon la revendication 1, caractérisé en ce qu'un réseau limiteur sert de résistance protectrice, ce réseau permettant une bonne dissipation de chaleur, pouvant supporter des tensions élevées, et consistant de préférence en plusieurs résistances individuelles (R1 à R9) montées en série.

3. Appareil de mesure selon l'une des revendications précédentes, caractérisé en ce qu'au moins l'une (R1) des résistances (R1 à R9) montées en série est une résistance à coefficient positif de température (R1).

4. Appareil de mesure selon l'une des revendications précédentes, caractérisé en ce que le dimensionnement des résistances (R1 à R9) montées en série est effectué de telle manière que la résistance totale limite le courant d'entrée à une valeur non dangereuse pour le circuit d'entrée du multimètre, que les arcs électriques produits s'éteignent et que la résistance à coefficient positif de température limite à une valeur admissible, après sa mise en fonction, la puissance dissipée au niveau des autres résistances individuelles montées en série.

5. Appareil de mesure selon l'une des revendications précédentes, caractérisé en ce que le nombre des résistances individuelles (R1 à R9) montées en série est choisi de telle manière que des résistances individuelles puissent être utilisées pour une puissance dissipée relativement réduite et avec une tension nominale relativement faible et qu'elles puissent prendre en charge la dissipation de puissance nécessaire lors de l'application d'une surtension.

6. Appareil de mesure selon l'une des revendications précédentes, caractérisé en ce qu'il peut être monté en parallèle à la résistance protectrice (R1 à R9) une résistance de redondance (R10 à R16) qui a une valeur ohmique plus élevée d'au moins un ordre de grandeur que la résistance protectrice (R1 à R9).

7. Appareil de mesure selon l'une des revendications précédentes, caractérisé en ce qu'un élément de signalisation (G) shunte, avec ses résistances série (R17 à R23) associées de valeur ohmique élevée, la résistance protectrice (R1 à R9) et l'entrée en série (E1, E2) du multimètre (M).

8. Appareil de mesure selon l'une des revendications précédentes, caractérisé en ce que l'adaptateur de mesure comporte un boîtier (1), configuré en tant que tête de mesure, dans lequel sont logés la résistance protectrice (R1 à R9) et, le cas échéant, d'autres composants (R10 à R23, G), et de préférence montés sur une carte imprimée (2) dans le boîtier (1).

9. Appareil de mesure selon l'une des revendications précédentes, caractérisé en ce que le boîtier (1) présente, à son extrémité libre non reliée au câble de mesure (L), un élément de contact (K1), de préférence une pointe de mesure, et en ce qu'il est configuré de manière à pouvoir être tenu commodément par une main.
